# EUROPEAN PATENT SPECIFICATION

(11) **EP 3 063 250 B1**
(45) Date of publication and mention of the grant of the patent: **01.08.2018**
(21) Application number: 14783540.9
(22) Date of filing: 02.10.2014
(51) Int. Cl.: C09K 11/59, C23C 16/455, C09K 11/02, C23C 16/40, C23C 16/44

(54) **SILICATE PHOSPHORS**
SILIKATLEUCHTSTOFFE
PHOSPHORES DE LA FAMILLE DES SILICATES

(30) Priority: 01.11.2013 US 201361898682 P
(43) Date of publication of application: 07.09.2016
(73) Proprietor: Merck Patent GmbH, 64293 Darmstadt (DE)
(72) Inventor: WINKLER, Holger, 64291 Darmstadt (DE); DAVIS, Monica, Lexington, MA 02420-3707 (US); HAMPEL, Christof, 65936 Frankfurt am Main (DE); OPOLKA, Andrea, 18516 Suederholz (DE); PETRY, Ralf, 64347 Griesheim (DE); SOETH, Olaf, 17493 Greifswald (DE); TEWS, Stefan, 17489 Greifswald (DE); GUMP, Christopher, Louisville, CO 80027 (US); KING, David, Canton, MA 02021 (US); SPENCER, Joseph A., Longmont, CO 80503 (US); SULLIVAN-TRUJILLO, Kassandra, Longmont, Colorado 80503 (US)
(86) International application number: PCT/EP2014/002685
(87) International publication number: WO 2015/062697

(56) References cited:
- US-A1- 2004 239 247
- US-A1- 2010 259 156
- US-A1- 2013 002 124
- US-A1- 2013 113 365

## Description

The invention relates to europium-doped silicate phosphors comprising a coating of aluminum oxide, to a process for the preparation of these phosphors, and to the use thereof as conversion phosphors or in lamps.

Inorganic fluorescent powders which can be excited in the blue and/or UV region of the spectrum are important for use as phosphors for phosphor-converted LEDs, pc-LEDs for short. Many phosphor material systems for pc-LEDs have been disclosed, for example alkaline-earth metal ortho-silicates, alkaline-earth metal oxy-ortho-silicates, thiogallates, garnets and nitrides, each of which are doped with Ce³⁺ or Eu²⁺.

Silicate compounds have been employed as conversion phosphor in pc-LEDs. With these very efficient phosphors an emission wavelength range from 430 to 650 nm is accessible by variation of the composition. Silicate based phosphors, such as ortho-silicates (EA₂SiO₄:Eu²⁺ with EA = earth alkaline of the group Ca, Sr, Ba or EA₃MgSi₂O₈:Eu²⁺) and oxy-ortho-silicates (EA₃SiO₅:Eu²⁺) are important down converters for LEDs and other lighting sources. These materials can be excited by (near-) UV and blue to greenish light and convert the pumping light into emission ranging from blue to orange (ortho-silicates) or yellow-orange to deep orange-red (oxy-ortho-silicates).

However, a disadvantage of these materials is their sensitivity to moisture, and some of these materials show poor stability in the lighting device, if operated at high temperature and high humidity. In particular, compounds having a high barium content in the crystal lattice gradually hydrolyze on contact with water. This results in destruction of the crystal lattice, causing the phosphor drastically to lose intensity.

Furthermore, not only does the intensity decrease, but one can also observe a change in emission color over time for these materials, especially when driven at high humidity and temperature. However, for use in white LEDs, it is important that the emission color of the phosphors remains unchanged over time. Otherwise, the LED changes its color point within the lifetime of the LED, which is a highly undesired effect.

Thus, it is desirable to find a solution in order to overcome the challenge of stability, also often referred as reliability, and to improve the reliability of these materials.

One way to do so, is to coat the surface of the phosphor particles. Reasons for doing this include particle protection, often against reaction with water, but also against reaction with air, other oxidants, or contaminants. Among the coating materials used for these purposes are ZnO, MgO, In₂O₃, Al₂O₃, TiO₂ and SiO₂.

Chemical vapor deposition (CVD) and sol-gel methods have been used to provide coatings of these types. To be effective, the applied coating should be as uniform and as thin as possible. It is also beneficial that the coating process does not cause individual particles to agglomerate to form larger aggregates. In addition to having much larger diameters than are wanted, these aggregates often tend to break apart, revealing defects in the coating at the break areas. The underlying particles are subject to attack from water, oxidants and other materials at the places where these defects occur. Neither CVD nor sol-gel techniques are entirely satisfactory, as agglomerates tend to form readily in these processes. In addition, these methods require relatively large amounts of raw materials, as only a portion of the applied reactants actually become applied to the surface of the phosphor particles. Quite often, material applied by these processes form separate particles instead of forming films on the surface of the phosphor particles. KR 2010-0002649 describes various silicate phosphors, which are coated with a metal oxide, in particular with SnO, TiO₂ or SiO₂, via a wet-chemical process. KR 2008-0056818 describes phosphors, in particular thiogallate phosphors, which are coated with Al₂O₃ via a wet-chemical process. KR 2008-0062619 describes a coating process for a number of phosphors, including silicate phosphors, by means of a precipitation process.

US 2010/0259156 A1 relates to surface-modified luminescent particles based on silicate phosphors, where at least one metal, transition metal or semimetal oxide layer and an organic coating are applied to the luminescent particles. The coatings in US 2010/0259156 A1 are applied by a wet chemical process or by a chemical vapour deposition (CVD) process.

There are still further improvements desired with respect to homogeneity of the coating as well as reliability of the phosphor material.

The object of the present invention is to develop alkaline-earth metal ortho-silicate and oxy-ortho-silicate phosphors with improved stability of the emission intensity to moisture and at the same time with improved stability of the color point of emission over time. A further object of the present invention is to provide a process for the preparation of these improved alkaline-earth metal ortho-silicate and oxy-ortho-silicate phosphors. In addition, an object of the invention also is to provide a mixture of the said alkaline-earth metal ortho-silicate or oxy-ortho-silicate phosphor with further phosphors. In addition, a further object of the invention consists in indicating various uses of these phosphors.

Surprisingly, it has now been found that europium-doped alkaline-earth metal ortho-silicate and oxy-ortho-silicate phosphors, which comprise a coating comprising aluminum oxide which is applied via a so-called atomic layer deposition (ALD) process solve the above-mentioned problem and show improved stability to moisture with respect to emission intensity as well as improved color stability. This is a surprising effect, as the state of the art does not show any effect in particular on the stability of the color point of emission. In this process, layers comprising alumina are grown at the surfaces of the silicate powders. The production process has considerable influence on the performance of the phosphor, and a phosphor coated by a wet-chemical process according to the state of the art as described above is different to a phosphor according to the invention.

Atomic layer deposition is an ultra-thin film deposition process, which has been described in detail in publications such as George, Chem. Rev. 2010, 110, 111-131. This gas phase process has been used to perform coatings on materials from highly patterned wafers such as semiconductor devices to ultra-fine powders and nanomaterials. The coating of fine powders by this technique has been described in detail by King et al. (Powder Technology 221 (2012) 13-25) and is furthermore described in US 6,613,383, US 6,713,177 and US 6,913,827.

The present invention therefore relates to a phosphor comprising a compound of the formula (I), (II) or (III),

(EA)₂₋ₓEuₓSiO₄ (I)

(EA)₃₋ₓEuₓSiO₅ (II)

(EA)_{3-x-y}MgEuₓMn_{y}Si₂O₈ (III)

where
- EA: stands for at least one element selected from Ca, Sr, and Ba, and might additionally contain Zn, Mg and/or Cu;
- x: stands for a value in the range 0.01 ≤ x ≤ 0.25;
- y: stands for a value in the range 0 ≤ y ≤ 0.1;
characterized in that the compound contains a coating of aluminum oxide (alumina) which has been deposited by an ALD process, wherein the deposit of alumina forms a conformal coating, characterized in that the thickest regions of the coating are no greater than 3x the thickness of the thinnest regions.

If EA contains Zn, the content of Zn is preferably ≤ 5 %, in particular ≤ 1%. If EA contains Mg, the content of Mg is preferably ≤ 1 %, in particular ≤ 0.1 %. If EA contains Cu, the Cu is preferably present as Cu²⁺, and the content of Cu is preferably ≤ 5 %, in particular ≤ 1 %. The percentage relates to all EA atoms present in the phosphor and are therefore atom%.

If the compound of formula (III) contains Mn, i.e. if y ≠ 0, then the content of Mn is preferably defined by 0.002 ≤ y ≤ 0.25, in particular 0.02 ≤ y ≤ 0.20.

In a preferred embodiment of the invention, the phosphor according to the invention consists of a compound of the formula (I), (II) or (III), which is coated with alumina by an ALD process.

EA in formula (I), (II) and (III) is preferably selected from Ba alone, Sr alone, Ca alone, Ba + Sr, Ba + Ca, Sr + Ca and Ba + Sr + Ca. In any of these embodiments, Zn, Mg and/or Cu might additionally be present. EA particularly preferably stands for one or more elements selected from Ba and Sr. All Ba:Sr ratios are accessible and can be preferred, depending on the desired emission color of the phosphor. Therefore, the Ba:Sr ratio is from 0:1 to 1:0.

If the compounds of formula (I), (II) or (III) contain Ca, then the content of Ca is preferably not more than 25% based on all atoms EA.

x preferably is a value in the range 0.03 ≤ x ≤ 0.20, particularly preferably a value in the range 0.04 ≤ x ≤ 0.13.

Europium is preferably exclusively in divalent form in the compound of the formula (I), (II) and (III) according to the invention.

The compounds of the formula (I) have an emission wavelength range from 505 to 615 nm, i.e. green to orange. The compounds of the formula (II) have an emission wavelength range from 585 to 605 nm. The compounds of the formula (III) have an emission wavelength range from 430 to 460 nm, if they contain only Eu as a dopant, and additionally from 620 to 650 nm, if they additionally contain Mn as a dopant. The emission wavelength of the phosphor according to the invention which has a coating of alumina applied by an ALD process is unchanged compared with the emission wavelengths of uncoated compound of formula (I), (II) and (III), respectively, i.e. the coating process does not have any influence on the initial emission color.

In the context of this application, blue light is regarded as light whose photoluminescence intensity maximum is at a wavelength between 420 and 459 nm, cyan light is regarded as light whose photoluminescence maximum is at a wavelength between 460 and 505 nm, green light is regarded as light whose photoluminescence intensity maximum is at a wavelength between 506 and 545 nm, yellow light is regarded as light whose photoluminescence intensity maximum is at a wavelength between 546 and 565 nm, orange light is regarded as light whose photoluminescence intensity maximum is at a wavelength between 566 and 600 nm, and red light is regarded as light whose photoluminescence intensity maximum is at a wavelength between 601 and 670 nm.

The phosphors according to the invention can be excited over a broad range, which extends from about 390 to 530 nm and in particular 410 to about 500 nm for phosphors according to formula (I) and (II) and from about 290 to about 410 nm for phosphors of formula (III). These phosphors are suitable not only for excitation by UV- or blue-emitting light sources, such as LEDs or conventional energy-discharge lamps (for example based on Hg), but also for light sources which utilise the blue In³⁺ line at 451 nm.

In a preferred embodiment of the invention, the compounds of formula (I), (II) and (III) before applying the coating as well as the phosphors according to the invention are in particulate form. The particle size of the compounds of formula (I), (II) or (III), before applying the coating of aluminum oxide, is usually in the range from 50 nm to 30 µm, preferably from 1 µm to 20 µm. These values relate to the average volumetric particle size d₅₀ determined by Coulter Counter measurement.

In a preferred embodiment of the present invention, the coating has a thickness between 0.5 and 100 nm, more preferably between 2 and 75 nm, most preferably between 3 and 50 nm and in particular between 5 and 20 nm.

In a further embodiment of the invention, the phosphors according to the invention are further treated with a hydrophobic compound in order to increase their hydrophobic nature and provide further protection against hydrolysis. The hydrophobic compound is conveniently applied as a final step in the ALD process. A suitable hydrophobic compound includes one or more alkyl or fluoroalkyl groups and at least one functional group that can react with a surface species on the surface of the particle and form a bond to the particle surface. An example for a suitable functional group is a silane or siloxane group having Si-H or Si-Hal functionalities wherein Hal is CI, Br or I. A hydrophobic coating can also be applied by other methods.

The phosphor particles according to the invention may also have a surface which carries functional groups which facilitate chemical bonding to the environment, preferably consisting of epoxy or silicone resin. These functional groups can be, for example, esters or other derivatives which are bonded via oxo groups and are able to form links to constituents of the binders based on epoxides and/or silicones. Surfaces of this type have the advantage that homogeneous incorporation of the phosphors into the binder is facilitated. Furthermore, the rheological properties of the phosphor/binder system and also the pot lives can thereby be adjusted to a certain extent. Processing of the mixtures is thus simplified.

The phosphors according to the invention have surprisingly high resistance to contact with moisture, as will be explained in greater detail below, and furthermore show stable emission color with almost no change in the color point over time.

The properties of the phosphors according to the invention explained above and shown in more detail below are unique to phosphors coated by an ALD process.

The invention furthermore relates to a process for the preparation of a phosphor according to the invention, comprising the following process steps:
a) provision of a compound of formula (I), (II) or (III); and
b) forming a layer of aluminum oxide (alumina) on the surface of the compound via an atomic layer deposition process.

Compounds of formula (I), (II) and (III) are known per se and at least some of them are commercially available. Any process for the synthesis of these compounds can be used. Preferably, the compounds are prepared by mixing europium- and silicon-containing compounds (preferably oxides, carbonates or oxalates) with barium- and/or strontium- and/or calcium- and optionally zinc-, magnesium- and/or copper-containing materials (likewise preferably oxides, carbonates or oxalates), in general with addition of at least one further inorganic or organic substance, which is usually employed as fluxing agent, and thermal treatment of the mixture. The oxides or carbonates of each of europium, silicon, barium, strontium, zinc and/or calcium are particularly preferably employed in each case. For compounds of formula (III), a magnesium-containing compound is used additionally, preferably MgO or MgCO₃, in particular MgCO₃. Furthermore, for Mn-containing compounds of formula (III), a manganese-containing compound is used additionally.

The reaction is usually carried out at a temperature above 800°C, preferably above 1200°C, particularly preferably between 1300 and 1500°C.

The said thermal treatment is preferably carried out at least partly under reducing conditions. The at least partially reducing conditions are established, for example, using carbon monoxide, forming gas or hydrogen (reducing conditions) or at least by means of vacuum or an oxygen-deficiency atmosphere (partially reducing conditions). A reducing atmosphere is preferably established by means of a nitrogen/hydrogen atmosphere and particularly preferably in a stream of N₂/H₂ (preferably in the range between 90:10 and 70:30).

The fluxing agents optionally employed are preferably at least one substance from the group of ammonium halides, in particular ammonium chloride, alkaline-earth metal fluorides, such as calcium fluoride, strontium fluoride or barium fluoride, carbonates, in particular ammonium hydrogencarbonate, or various alkoxides and/or oxalates. In the case of the use of the said alkaline-earth metal fluorides as fluxing agents, however, the proportion thereof must be included in the stoichiometric ratio of the components in the formula (I), (II) and (III), respectively. Ammonium chloride is particularly preferably employed.

The compounds of the formula (I), (II) and (III) are preferably prepared by a solid-state diffusion method as described above. However, processes are also known by means of which the phosphors can be prepared by wet-chemical methods from the corresponding inorganic and/or organic salts via a sol-gel process, coprecipitation process and/or drying process. Any of these methods to prepare the compounds of the formula (I), (II) and (III) can be used as an alternative to the solid-state diffusion method.

The atomic layer deposition (ALD) process is for example described in US 2012/0199793 A1 (University of Colorado). The ALD process is characterized in that at least two different reactants are needed to form the coating layer. The reactants are introduced into the reaction zone individually, sequentially and in the gas phase. Excess amounts of reactant are removed from the reaction zone before introducing the next reactant. Reaction by-products are removed as well, between introductions of the reagents. This procedure ensures that reactions occur at the surface of the phosphor particles, rather than in the gas phase. Gas phase reactions, such as occur in chemical vapor deposition (CVD) processes, are undesirable for several reasons. CVD reactions tend to cause particle agglomeration, form uneven and non-conformal coatings and use greater amounts of raw materials than desired due to the formation of undesired side products.

A purge gas is typically introduced between the alternating feeds of the reactants, in order to further help to remove excess reactants. A carrier gas, which is usually, but not necessarily the same as the purge gas, generally is introduced during the time each reactant is introduced. The carrier gas may perform several functions, including (1) facilitating the removal of excess reactant and reaction by-products, (2) distributing the reactant through the reaction zone, thereby helping to expose all particle surfaces to the reactant and (3) fluidizing the phosphor particles so that all particle surfaces become exposed to the reactant.

A typical pattern of introducing reactants is:
1. Introduce purge/fluidizing gas.
2. Introduce mixture of carrier gas and first reagent.
3. Introduce purge/fluidizing gas and/or pull a high vacuum to remove excess quantities of the first reagent as well as reaction by-products.
4. Introduce mixture of carrier gas and second reagent.
5. Introduce purge/fluidizing gas and/or pull a high vacuum to remove excess quantities of the second reagent and reaction by-products.
6. Repeat steps 2-5 until desired coating thickness is obtained.

As mentioned, the same material may be used as the purge/fluidizing gas and each carrier gas. It is also possible to use different materials or combinations of materials. The preferred purge/fluidizing and carrier gases are nitrogen or argon.

Such atomic layer controlled growth techniques permit the formation of deposits of up to about 0.3 nm in thickness per reaction cycle, and thus provide a means of extremely fine control over deposit thickness. The reactions are self-limited and in most instances can be repeated to sequentially deposit additional layers of the deposited material until a desired thickness is achieved.

It is preferred to treat the particles before initiating the reaction sequence to remove volatile materials that may be adsorbed onto the particle surface. This is readily done by exposing the particles to elevated temperatures and/or vacuum. Also, in some instances a precursor reaction may be performed to introduce desirable functional groups onto the surface of the particle.

Reaction conditions are selected mainly to meet two criteria. The first criterion is that the reagents are gaseous under the conditions of the reaction. Therefore, temperature and pressure conditions are selected such that the reactants are volatilized. The second criterion is one of reactivity. Conditions, particularly temperature, are selected such that the desired reaction between the film-forming reagents (or, at the start of the reaction, the first-introduced reagent and the particle surface) occur at a commercially reasonable rate.

The temperature of the reactions may range from 250-700 K. The temperature is preferably no greater than about 475 K and more preferably no greater than 425 K. Temperatures in excess of these tend to cause diffusion of the luminescent centers from the crystalline lattice of the host material, which destroys or diminishes the ability of the particle to emit light.

Specific temperature and pressure conditions will depend on the particular reaction system, as it remains necessary to provide gaseous reactants. Subatmospheric pressures will normally be required.

A suitable apparatus for conducting the ALD reaction is one which permits the particles to become separated so that all particle surfaces become exposed to the reagents. One convenient method for exposing the base particles to the reagents is to form a fluidized bed of the particles and then pass the various reagents in turn through the fluidized bed under reaction conditions. Methods of fluidizing particulate materials are well known, and generally include supporting the particles on a porous plate or screen. A fluidizing gas is passed upwardly through the plate or screen, lifting the particles somewhat and expanding the volume of the bed. With appropriate expansion, the particles behave much as a fluid. The reagents can be introduced into the bed for reaction with the surface of the particles. In this invention, the fluidizing gas also can act as the inert purge gas for removing unreacted reagents and volatile or gaseous reaction products.

In addition, the reactions can be conducted in a rotating cylindrical vessel or a rotating tube. A rotating reactor comprises a hollow tube that contains the base particles. The reactor may be held at an angle to the horizontal, so that the particles pass through the tube through gravitational action. In such a case, the reactor angle determines the flow rate of the particulates through the reactor. The reactor can be rotated in order to distribute individual particles evenly and expose all particles to the reagents. The reactor design permits the substrate particles to flow in a near plug-flow condition, and is particularly suitable for continuous operations. The rotating cylindrical vessel can also be sealed on both ends and have porous metal walls that allow the gases to flow in and out of the rotating cylindrical vessel. This rotary reactor is convenient for static reactant exposures and batch processing of phosphor particles.

The progress of the reaction can be monitored using techniques such as transmission Fourier transform infrared techniques, transmission electron spectroscopy, scanning electron microscopy, Auger electron spectroscopy, x-ray fluorescence, x-ray photoelectron spectroscopy and x-ray diffraction.

The silicate compounds of formula (I), (II) and (III) all contain -O-H functional groups on the surface, which can serve as a site through which the first-applied ALD reagent can become bonded to the substrate particle. These functional groups are usually present from the synthesis of the compound and its exposure to atmospheric conditions.

The coating applied by the ALD method according to the invention contains aluminum oxide (alumina). Preferably, the coating consists exclusively of alumina.

An advantage of the ALD method is that the process is capable of forming highly uniform films at very small thicknesses. Film thickness is controlled via the number of reaction cycles that are performed. Film thickness is measured through elemental composition analysis, transmission electron microscopy, energy-dispersive x-ray spectroscopy, application testing, other methods, or a combination thereof.

The particulate is preferably non-agglomerated after the alumina layer is deposited. By "non-agglomerated", it is meant that the particles do not form significant amounts of agglomerates during the process of coating the particles. Particles are considered to be non-agglomerated if (a) the average particle size does not increase more than about 5%, preferably not more than about 2%, more preferably not more than about 1% (apart from particle size increases attributable to the coating itself and apart from fine particle losses due to flow conditions and filtration) as a result of depositing the coating, or (b) if no more than 2 weight%, preferably no more than 1 weight% of the particles become agglomerated during the process of depositing the alumina layer. This can be verified by particle size distribution analysis, imaging, application testing, or a combination thereof.

The deposit of alumina forms a conformal coating. By "conformal" it is meant that the thickness of the coating is relatively uniform across the surface of the particle so that the thickest regions of the coating are no greater than 3x (preferably no greater than 2x, especially no greater than 1.5x) the thickness of the thinnest regions), so that the surface shape of the coated compound closely resembles that of the underlying compound surface. Conformality is determined by methods such as transmission electron spectroscopy (TEM) that have resolution of 10 nm or below. Lower resolution techniques cannot distinguish conformal from non-conformal coatings at this scale. The compound is preferably coated substantially without pinholes or defects. These properties are achieved by using an ALD method.

The alumina coating can be prepared on the particles having surface hydroxyl groups using the binary (AB) reaction sequence as follows. The asterisk (*) indicates the atom that resides at the surface of the particle or coating. X is a displaceable nucleophilic group. The reactions below are not balanced and are only intended to show the general principle of the reactions at the surface of the particles.

Si-O-H* + AlX₃ → Si-O-AlX* + HX (A1)

Si-O-AlX* + H₂O → Si-O-AlOH* + HX (B1)

Si-O-H indicates the surface of the silicate phosphor. In reaction (A1), reagent AlX₃ reacts with one or more Si-O-H groups on the surface of the particle to create a new surface group having the form -Al-X. Al is bonded to the particle through one or more oxygen atoms. The -Al-X group represents a site that can react with water in reaction (B1) to generate one or more hydroxyl groups. The hydroxyl groups formed in reaction (B1) can serve as functional groups through which reactions (A1) and (B1) can be repeated, each time adding a new layer of Al atoms. This condensation reaction can be promoted if desired by, for example, annealing at elevated temperatures and/or reduced pressures.

These reactions are described in more detail in A. C. Dillon et al., Surface Science 322, 230 (1995) and A. W. Ott et al., Thin Solid Films 292, 135 (1997).

A specific reaction sequence of the (A1)/(B1) type that produces alumina is:

Al(CH₃)* + H₂O → Al-OH* + CH₄ (A1A)

Al-OH* + Al(CH₃)₃ → Al-O-Al(CH₃)₂* + CH₄ (B1A)

This particular sequence of reactions is particularly preferred to deposit alumina, as the reactions proceed well even at temperatures below 350°K. Triethyl aluminum (TEA) or other trialkyl aluminum as well as aluminum trichloride or other aluminum trihalides can be used in place of trimethyl aluminum (TMA). Other oxidizers such as oxygen plasma radicals, ozone, alcohols, water containing isotopic oxygen and more can be used in place of normal water.

In the preferred embodiment of the present invention, a number of cycles between 1 and 1000 cycles is performed, very preferably between 10 and 500 cycles, and especially preferred between 50 and 200 cycles.

The phosphors according to the invention can be used as conversion phosphors. They can also be mixed with other phosphors, and, in particular if they have a comparatively high relative content of barium (λₘₐₓ < 545 nm), preferably with red-emitting phosphors, making mixtures of this type very highly suitable for applications in general lighting (for example for warm-white LEDs) and LCD backlighting.

The present invention therefore furthermore relates to a mixture comprising at least the phosphor according to the present invention and at least one further phosphor, preferably a red-emitting or orange-emitting phosphor, if the phosphor according to the invention is a green or yellow-emitting phosphor, or green-emitting or cyan-emitting phosphor, if the phosphor according to the invention is an orange- or red-emitting phosphor.

Suitable red-emitting or orange-emitting phosphors are selected from Eu-doped sulfoselenides, Eu- and/or Ce-doped nitrides, oxynitrides, alumosiliconitrides, Mn(IV)-doped oxides and/or fluorides and/or oxy-ortho-silicates, which can also be coated compounds according to the present invention. Suitable material systems which are known to the person skilled in the art are siliconitrides and alumosiliconitrides (cf. Xie, Sci. Technol. Adv. Mater. 2007, 8, 588-600), 2-5-8 nitrides, such as (Ca,Sr,Ba)₂Si₅N₈:Eu²⁺ (Li et al., Chem. Mater. 2005, 15, 4492), and alumosiliconitrides, such as (Ca,Sr)AlSiN₃:Eu²⁺ (K. Uheda et al., Electrochem. Solid State Lett. 2006, 9, H22) or variants of the said compounds, in which individual lattice positions are substituted by other chemical elements, such as alkali metals, aluminum, gallium or gadolinium, or further elements of this type occupy flaws as dopant. Further preferred red phosphors are α-SiAlON of the formula (EA)ₓEu_{y}(Si,Al)₁₂(O,N)₁₆. Further preferred are compounds of the formula (EA)_{2-0.5y-x}EuₓSi₅N_{8-y}O_{y} and (EA)_{2-x+1.5z}EuₓSi₅N_{8-2/3x-z}Oₓ where EA stands for one or more elements selected from Ca, Sr and Ba, x is a value in the range from 0.005 to 1, y is a value in the range from 0.01 to 3 and z is a value in the range from 0 to 2. These compounds can furthermore contain SiO₂ and/or Si₃N₄. Compounds of this type are described in greater detail in EP 2528991. In these compounds, EA in preferred embodiments stands for Sr, while x in preferred embodiments is a value in the range from 0.01 to 0.8, preferably in the range 0.02 to 0.7 and particularly preferably in the range 0.05 to 0.6 and especially preferably in the range 0.1 to 0.4, and y in preferred embodiments is a value in the range from 0.1 to 2.5, preferably in the range from 0.2 to 2 and particularly preferably in the range from 0.22 to 1.8, and z in preferred embodiments is a value in the range of 0 to 1, in particular 0.

The green-emitting phosphor is preferably selected from garnets, such as LuAG, LuGaAG, YAG, YGaAG, Gd-doped LuAG, Gd-doped YAG, which can also additionally contain alkaline earth halide, such as BaF₂, ortho-silicates, which can also be coated compounds according to the present invention, or β-SiAlON.

It might be preferred that the further phosphors used in combination with the phosphors according to the present invention also have a coating, in particular a coating of aluminum oxide, preferably applied by an ALD process. This is in particular the case when the further phosphor is a silicate phosphor.

**Table 1: Red, orange, green and cyan emitting phosphors, which can be used in combination with the phosphors according to the invention**

| **Composition** | **Emission color** | **λ ₘₐₓ [nm]** |
|---|---|---|
| LaAl(Si_{6-z}Al_{z})-(N_{10-z}O_{z}):Ce | cyan | 460 - 500 |
| CaSi₂O_{2-z}N_{2+2/3z}:Eu | green | 534 - 562 |
| γ-AlON:Mn-Mg | green | 512 |
| (Ba₁-ₓSrₓ)₂SiO₄:Eu | green | 520 - 560 |
| SrGa₂S₄:Eu | green | 535 |
| SrSi₂N₂O₂:Eu | green | 535 - 554 |
| SrAlSi₄N₇:Eu | cyan and red | 500, 632 |
| Ba₂ZnS₃:Ce, Eu | cyan and red | 498, 655 |
| (Sr₁₋ₓCaₓ)₂SiO₄:Eu | orange | 560 - 600 |
| MgS:Eu | orange | 580 |
| Sr₃SiO₅:Eu | orange | 570 |
| Ca₂BO₃Cl:Eu | orange | 573 |
| Li-α-SiAlON:Eu | orange | 573 |
| CaAlSiN₃:Ce | orange | 580 |
| SrLi₂SiO₄:Eu | orange | 562 |
| Ca₂SiS₄:Eu | orange to red | 550, 660 |
| Y₃Mg₂AlSi₂O₁₂:Ce | orange to red | 600 |
| (Ca_{1-x-y}SrₓBa_{y})₂Si₅N₈:Eu | orange to red | 580 - 640 |
| (Ca₁₋ₓSrₓ)AlSiN₃:Eu | red | 630 - 650 |
| Lu₂CaMg₂Si₃O₁₂:Ce | red | 605 |
| Sr₃(Al₂O₅)Cl₂:Eu | red | 610 |
| Sr₂Si₅N₈:Eu | red | 625 |
| CaSiN₂:Ce | red | 625 |
| SrSiN₂:Eu | red | 670 - 685 |
| (Ca₁₋ₓSrₓ)S:Eu | red | 610 - 655 |
| SrSiO₅:Ce, Li | cyan to red | 465 - 700 |
| Ca-α-SiAlON:Eu | cyan to red | 500 - 700 |
| MgSiN₂:Mn | yellow to red | 550 - 800 |

In the mixture according to the invention comprising at least one phosphor according to the invention and at least one further phosphor, in particular at least one red-emitting or green-emitting phosphor, the ratio of phosphors according to the invention and the further phosphor(s) is in accordance with the invention 25:1 to 1:1, based on the total weight of the phosphors. It is preferred in accordance with the invention for the at least one phosphor according to the invention and the at least one further phosphor, in particular the at least one green-yellow-emitting or orange-red-emitting phosphor, to be present in the weight ratio of green-yellow emitting to orange-red-emitting phosphor of 10:1 to 3:1 and particularly preferably 6:1 to 4:1, based on the total weight of these phosphors.

The phosphors according to the invention can particularly advantageously be employed in light-emitting diodes (LEDs), and especially in the pc-LEDs already mentioned above.

For use in LEDs, the phosphors according to the invention can also be converted into any desired other outer shapes, such as spherical particles, flakes and structured materials and ceramics. These shapes are usually summarized under the term "shaped bodies". The shaped body here is preferably a "phosphor body".

The phosphors according to the invention are therefore particularly preferably employed in shaped bodies, or in phosphor bodies, comprising the silicate phosphors according to the invention.

The production of ceramic phosphor bodies comprising the phosphors according to the invention is preferably carried out analogously to the process described in DE 10349038. The said patent specification is therefore incorporated in its full scope into the context of the present application by way of reference. In this process, the phosphor is subjected to isostatic pressing and applied directly to the surface of a chip in the form of a homogeneous, thin and non-porous flake. There is thus no location-dependent variation of the excitation and emission of the phosphor, which means that the LED provided therewith emits a homogeneous light cone of constant color and has high light output. The ceramic phosphor bodies can be produced on a large industrial scale, for example, as flakes in thicknesses of a few 100 nm to about 500 µm. The flake dimensions (length x width) are dependent on the arrangement. In the case of direct application to the chip, the size of the flake should be selected in accordance with the chip dimensions (from about 100 µm * 100 µm to several mm²) with a certain oversize of about 10% to 30% of the chip surface with a suitable chip arrangement (for example flip-chip arrangement) or correspondingly. If the phosphor flake is installed over a finished LED, all of the exiting light cone passes through the flake.

The side surfaces of the ceramic phosphor body can be coated with a light metal or noble metal, preferably aluminum or silver. The metal coating has the effect that light does not exit laterally from the phosphor body. Light exiting laterally can reduce the luminous flux to be coupled out of the LED. The metal coating of the ceramic phosphor body is carried out in a process step after the isostatic pressing to give rods or flakes, where the rods or flakes can optionally be cut to the requisite size before the metal coating. To this end, the side surfaces are wetted, for example, with a solution comprising silver nitrate and glucose and subsequently exposed to an ammonia atmosphere at elevated temperature. A silver coating, for example, forms on the side surfaces in the process. Alternatively, currentless metallisation processes are also suitable, see, for example, Hollemann-Wiberg, Lehrbuch der Anorganischen Chemie [Textbook of Inorganic Chemistry], Walter de Gruyter Verlag or Ullmanns Enzyklopädie der chemischen Technologie [Ullmann's Encyclopaedia of Chemical Technology].

The ceramic phosphor body can, if necessary, be fixed to an LED chip serving as baseboard using a water-glass solution.

In a preferred embodiment, the ceramic phosphor body has a structured (for example pyramidal) surface on the side opposite an LED chip. This enables as much light as possible to be coupled out of the phosphor body. The structured surface on the phosphor body is produced by carrying out the isostatic pressing using a compression mould having a structured pressure plate and thus embossing a structure into the surface. Structured surfaces are desired if the aim is to produce the thinnest possible phosphor bodies or flakes. The pressing conditions are known to the person skilled in the art (see J. Kriegsmann, Technische keramische Werkstoffe [Industrial Ceramic Materials], Chapter 4, Deutscher Wirtschaftsdienst, 1998). It is important that the pressing temperatures used are 2/3 to 5/6 of the melting point of the substance to be pressed.

However, embodiments for the application of the phosphors according to the invention to a light-emitting diode are also possible (see Example 4, GaN chip as LED chip), in which a phosphor layer to be applied, which is intended to comprise the phosphors according to the invention, is applied by bulk casting, preferably by bulk casting from a mixture of silicone or an epoxy resin and homogeneous silicate phosphor particles.

The present invention furthermore relates to a light source which comprises a semiconductor and at least one phosphor according to the invention.

Particular preference is given here to a light source which comprises a semiconductor and at least one phosphor according to the invention and at least one other, orange-red-emitting or green-yellow-emitting phosphor. This light source is preferably white-emitting or emits light having a certain color point (color-on-demand principle). The color-on-demand concept is taken to mean the production of light having a certain color point using a pc-LED (= phosphor-converted LED) using one or more phosphors.

The red-emitting and green-emitting phosphors employed here are preferably the red-emitting and green-emitting phosphors already described in greater detail above.

In a preferred embodiment of the light source according to the invention, the semiconductor is a luminescent indium aluminum gallium nitride, in particular of the formula InᵢGaⱼAlₖN, where 0 ≤ i, 0 ≤ j, 0 ≤ k, and i + j + k = 1. These can be light-emitting LED chips of various structure.

In a further preferred embodiment of the light source according to the invention, the light source is a luminescent arrangement based on ZnO, TCO (transparent conducting oxide), ZnSe or SiC or an arrangement based on an organic light-emitting layer (OLED).

In a further preferred embodiment of the light source according to the invention, the light source is a source which exhibits electroluminescence and/or photoluminescence. The light source may furthermore also be a plasma or discharge source or a laser.

The phosphors according to the invention can either be dispersed in a resin (for example epoxy or silicone resin) or, in the case of suitable size ratios, arranged directly on the light source or alternatively arranged remote therefrom, depending on the application (the latter arrangement also includes "remote phosphor technology"). The advantages of remote phosphor technology are known to the person skilled in the art and are revealed, for example, by the following publication: Japanese J. of Appl. Phys. Vol. 44, No. 21 (2005), L649-L651.

The optical coupling of the lighting unit described above between the silicate phosphor or the phosphor mixture comprising the silicate phosphor according to the invention and the semiconductor can also be achieved by a light-conducting arrangement. This makes it possible for the semiconductor to be installed at a central location and to be optically coupled to the phosphor by means of light-conducting devices, such as, for example, optical fibres. In this way, it is possible to achieve lamps adapted to the lighting wishes which merely consist of one or various phosphors, which can be arranged to form a light screen, and an optical waveguide, which is coupled to the light source. In this way, it is possible to place a strong light source at a location which is favourable for electrical installation and to install lamps comprising phosphors which are coupled to the optical waveguides at any desired locations without further electrical cabling, but instead only by laying optical waveguides.

The invention furthermore relates to a lighting unit, in particular for the backlighting of display devices, which comprises at least one light source described above and thus at least one phosphor according to the invention. Lighting units of this type are employed principally in display devices, in particular liquid-crystal display devices (LC displays), having backlighting. The present invention therefore also relates to a display device of this type.

The present invention furthermore relates to the use of the phosphors according to the invention as conversion phosphor, preferably for the partial or complete conversion of the blue or near-UV emission from a luminescent diode. Near-UV emission in the sense of this application means emission in a wavelength range from 370 to 419 nm.

Preference is furthermore given to the use of the phosphors according to the invention for the conversion of blue or near-UV emission into visible white radiation.

The use of the phosphors according to the invention in electroluminescent materials, such as, for example, electroluminescent films (also known as lighting films or light films), in which, for example, zinc sulfide or zinc sulfide doped with Mn²⁺, Cu⁺ or Ag⁺ is employed as emitter, which emit in the yellow-green region is also advantageous in accordance with the invention. The areas of application of the electroluminescent film are, for example, advertising, display backlighting in liquid-crystal display screens (LC displays) and thin-film transistor (TFT) displays, self-illuminating vehicle licence plates, floor graphics (in combination with a crush-resistant and slip-proof laminate), in display and/or control elements, for example in automobiles, trains, ships and aircraft, or also domestic appliances, garden equipment, measuring instruments or sport and leisure equipment.

Compared with silicate phosphors of the formula (I), (II) and (III) according to the state of the art, which are not coated with alumina by an ALD process, the phosphors according to the invention have excellent resistance to moisture, which permanently reduces the drop in the intensity of the phosphor over an extended period in contact with atmospheric moisture.

In addition, the phosphors according to the invention have emission spectra whose maximum is neither shifted nor reduced compared with the emission maximum of commercially available silicate phosphors which have not been coated with alumina with an ALD process, thus showing a stable color point over time.

The phosphors according to the invention can be employed successfully in all conventional application media in which conventional compounds of formula (I), (II) or (III) are employed.

The following examples are intended to illustrate the present invention. However, they should in no way be regarded as limiting. All compounds or components which can be used in the compositions are either known and commercially available or can be synthesised by known methods. The temperatures indicated in the examples are in °C. It furthermore goes without saying that, both in the description and also in the examples, the added amounts of the components in the compositions always add up to a total of 100%. Percentage data given should always be regarded in the given context. However, they usually always relate to the weight of the part-amount or total amount indicated.

### Examples

The enhanced stability of ALD-treated silicate phosphors is shown by the examples as follows:

### Example 1: Comparison between ALD-treated ortho-silicate of emission peak wavelength 515 nm stabilized by 100 cycles coating with untreated pure ortho-silicate of 515 nm wavelength

The ortho-silicate used has the formula Ba_{1.8}Sr_{0.15}SiO₄:Eu_{0.05}.

### Deposition of the Al₂O₃ coating:

An ALD film was deposited using trimethylaluminum and water vapor. One hundred (100) A-B cycles were performed at reduced pressure and 180°C within a 500 mL stainless steel fluidized bed reactor (600 g batch). The precursors were alternately dosed between nitrogen purges, to ensure ALD reactions and not CVD. N₂ is used as the carrier gas.

### Example 2: Comparison between ALD-treated ortho-silicate of emission peak wavelength 565 nm stabilized by 100 cycles coating with untreated pure ortho-silicate of 565 nm wavelength

The ortho-silicate used has the formula Ba_{0.35}Sr_{1.59}SiO₄:EU_{0.06}.

### Deposition of the Al₂O₃ coating:

An ALD film was deposited using trimethylaluminum and water vapor. One hundred (100) A-B cycles were performed at reduced pressure and 180°C within a 2L and 8L stainless steel fluidized bed reactor (5kg and 17kg batches, respectively). The precursors were alternately dosed between nitrogen purges, to ensure ALD reactions and not CVD. N₂ is used as the carrier gas.

### Example 3: Comparison between ALD-treated oxy-ortho-silicate emitting at 585 nm and stabilized with 100 coating cycles against untreated oxy-ortho-silicate of 585 nm wavelength

The oxy-ortho-silicate used has the formula Ba_{0.10}Sr_{2.86}SiO₅:Eu_{0.04}.

### Deposition of the Al₂O₃ coating:

An ALD film was deposited using trimethylaluminum and water vapor. One hundred (100) A-B cycles were performed at reduced pressure and 180°C within a 500mL stainless steel fluidized bed reactor (600g batch). The precursors were alternately dosed between nitrogen purges, to ensure ALD reactions and not CVD. N₂ is used as the carrier gas.

### Example 4: Comparison between ALD-treated oxy-ortho-silicate emitting at 600 nm (stabilized with 100 cycles) against untreated oxy-ortho-silicate of 600 nm wavelength

The oxy-ortho-silicate used has the formula Ba_{0.60}Sr_{2.34}SiO₅:Eu_{0.04}.

### Deposition of the Al₂O₃ coating:

An ALD film was deposited using trimethylaluminum and water vapor. Both fifty (50) and one hundred (100) A-B cycles were performed at reduced pressure and 180°C within a 500 mL stainless steel fluidized bed reactor (600 g batch). The precursors were alternately dosed between nitrogen purges, to ensure ALD reactions and not CVD. N₂ is used as the carrier gas. Coatings of 100 cycles were also performed on 2L and 8L batches (5 kg and 17 kg, respectively).

### Example 5: Comparative example - coating of an ortho-silicate of emission peak wavelength 565 nm with Al₂O₃ by applying a wet chemical method according to the prior art

The ortho-silicate used is the same as in Example 2. 15 g of the ortho-silicate phosphor is dispersed in 135 ml dried ethanol under vigorous stirring. 15 ml of concentrated NH₃ solution is added stepwise and after 30 minutes of stirring 2.208 g Al(NO₃)₃*9H₂O is given to the suspension. The suspension is stirred for 2 hours and in this time every 15 minutes 30 seconds of ultrasound is applied. The as-coated phosphor is then filtered, washed with ethanol-water mixture and dried. After drying a calcination under 350°C is applied followed by 36 µm sieving.

### Example 6: Prototype LED fabrication

The prototype LEDs used for the LED reliability tests are fabricated as follows: Silicone binder (OE 6550, Dow Corning) and phosphors according to examples 1 to 5 or the corresponding uncoated phosphors are mixed in the weight ratio 100:10. The slurries are filled into LED empty packages of 3528 type equipped with blue die emitting at 450 nm (operation at 20 mA) by means of volume dispensing. The silicone is cured for 2 h at 150°C.

### Example 7: LED reliability test

LEDs fabricated as described are introduced into a climate chamber operating at 85°C / 85% rel. humidity. The LEDs are stored under these conditions for at least 1000 h and driven at 20 mA (constant operation). Within this timeframe, the devices are taken out of the climate chamber several times to characterize the chromaticity and the LED brightness by means of a spectroradiometer at 20 mA driving conditions. After completion of measurements the LEDs are reinstalled into the climate chamber.

According to E. Fred Schubert "Light-Emitting Diodes", Cambridge University Press (2003) the lifetime of an LED is >> 1000 hrs. The human eye can differentiate chromaticity differences of Δx = Δy ≅ 0.004.

### Description of the figures

**Figure 1****:**
   **a)** Fluorescence emission spectrum of ALD-treated [100 cycles coating according example 1] and untreated ortho-silicate powders with peak wavelength 515 nm. The intensity and emission band shape remains unchanged after deposition process. A: emission bands of phosphors, excited at 430 nm; grey curve: ALD treated ortho-silicate; black curve: untreated ortho silicate.
   **b)** LED reliability test (85°C, 85% rel. humidity, storage time t = 1000 h) diagram: Intensity (brightness) of LEDs built with ALD treated ortho-silicate (according to example 1, curve A) versus intensity of LEDs built with untreated ortho-silicate emitting at 515 nm (curve B): the LED intensity of the ALD treated phosphor remains almost unchanged; in contrast the brightness of the LED built with untreated phosphor decreases.
   **c)** LED reliability test (85°C, 85% rel. humidity, storage time t = 1000 h) diagram: LED Color point CIE 1931 x, y -change with A/B being CIE 1931 x/y of LED built with ALD treated ortho-silicate (according example 1) and C/D being CIE 1931 x/y of LED built with untreated 515 nm emitting ortho-silicate: the behavior of the LED with ALD treated phosphor remains almost unchanged. In contrast the LED built with untreated phosphor shows strong shift of color point during reliability testing.
**Figure 2****:**
   **a)** Fluorescence emission spectrum of untreated, wet chemical Al₂O₃ coated (according to example 5) and ALD treated ortho-silicate (according to example 2) powder with peak wavelength 565 nm, excited at 450 nm: the intensity and emission band shape remains unchanged after coating.
   **b)** LED reliability test (85°C, 85% rel. humidity, storage time t = 2000 h) diagram: Intensity (brightness) of LEDs built with wet chemical treated ortho-silicate (according to example 5, curve B) versus intensity of LEDs built with ALD treated ortho-silicate (according to example 2, curve A) and intensity of LEDs built with untreated ortho-silicate emitting at 565 nm (curve C): the LED intensity of the ALD treated phosphor remains almost unchanged; in contrast the brightness of the LED built with wet chemical treated and untreated phosphor decreases.
   **c)** LED reliability test (85°C, 85% rel. humidity, storage time t = 2000 h) diagram: LED color point CIE 1931 x, y -change with A/B being CIE 1931 x/y of LED built with ALD treated ortho-silicate (according example 2), C/D being CIE 1931 x/y of LED built with untreated 565 nm emitting ortho-silicate, and E/F being CIE 1931 x/y of LED built with wet chemical treated 565 nm emitting ortho-silicate (according to example 5): the behavior of the LED with ALD treated phosphor remains almost unchanged. In contrast the LED built with untreated and wet chemical treated phosphor shows strong shift of color point during reliability testing.
**Figure 3****:**
   **a)** Fluorescence emission spectrum of ALD-treated [100 cycles coating according example 3] and untreated oxy-ortho-silicate powders with peak wavelength 585 nm: the intensity and emission band shape remains almost unchanged after deposition process. A: emission bands of phosphors, excited at 450 nm; grey curve: ALD treated oxy-ortho-silicate; black curve: untreated oxy-ortho-silicate.
   **b)** LED reliability test (85°C, 85% rel. humidity, storage time t = 1000 h) diagram: Intensity (brightness) of LEDs built with ALD treated oxy-ortho-silicate according to example 3 versus intensity of LEDs built with untreated oxy-ortho-silicate emitting at 585 nm (B): the LED intensity of the ALD treated phosphor remains almost unchanged; in contrast the brightness of the LED built with untreated phosphor decreases.
   **c)** LED reliability test (85°C, 85% rel. humidity, storage time t = 1000 h) diagram: LED Color point CIE 1931 x, y -change with A/ B being CIE 1931 x / y of LED built with ALD treated oxy-ortho-silicate according example 3 and C / D being CIE 1931 x / y of LED built with untreated 585 nm emitting oxy-ortho-silicate: the behavior of the LED with ALD treated phosphor remains almost unchanged. In contrast the LED built with untreated phosphor shows strong decay of color point during reliability testing.
**Figure 4****:**
   **a)** Fluorescence emission spectrum of ALD-treated [100 cycles coating according example 4] and untreated oxy-ortho-silicate powders with peak wavelength 600 nm: the intensity and emission band shape remains almost unchanged after deposition process. A: emission bands of phosphors, excited at 450 nm; grey curve: ALD treated oxy-ortho-silicate; black curve: untreated oxy-ortho silicate.
   **b)** LED reliability test (85°C, 85% rel. humidity, storage time t = 1000 h) diagram: Intensity (brightness) of LEDs built with ALD treated oxy-ortho-silicate according to example 4 versus intensity of LEDs built with untreated oxy-ortho-silicate emitting at 600 nm (B): the LED intensity of the ALD treated phosphor remains almost unchanged; in contrast the brightness of the LED built with untreated phosphor decreases.
   **c)** LED reliability test (85°C, 85% rel. humidity, storage time t = 1000 h) diagram: LED Color point CIE 1931 x, y -change with A/ B being CIE 1931 x / y of LED built with ALD treated oxy-ortho-silicate according example 4 and C / D being CIE 1931 x / y of LED built with untreated 600 nm emitting oxy-ortho-silicate: the behavior of the LED with ALD treated phosphor remains almost unchanged. In contrast the LED built with untreated phosphor shows strong decay of color point during reliability testing.

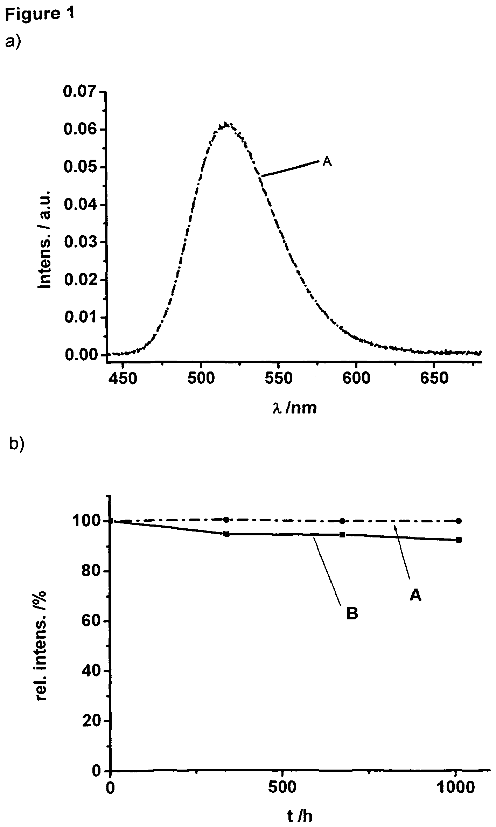

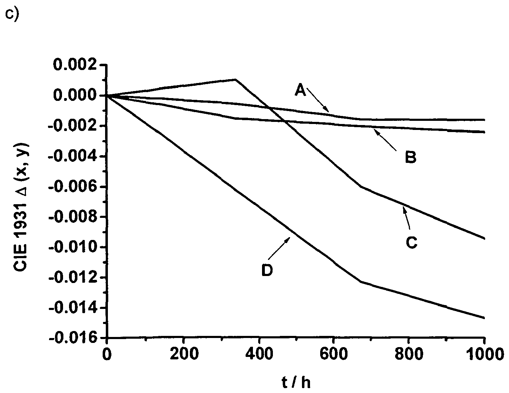

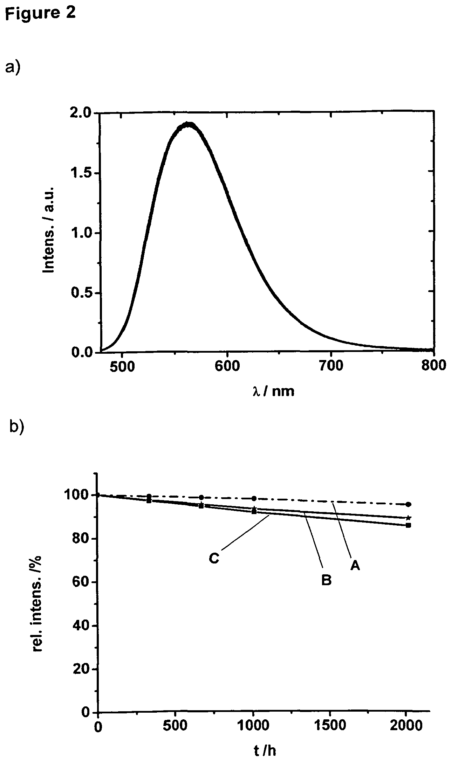

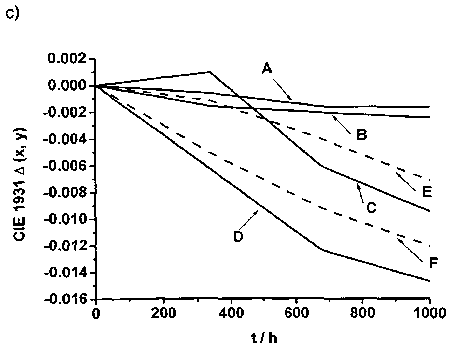

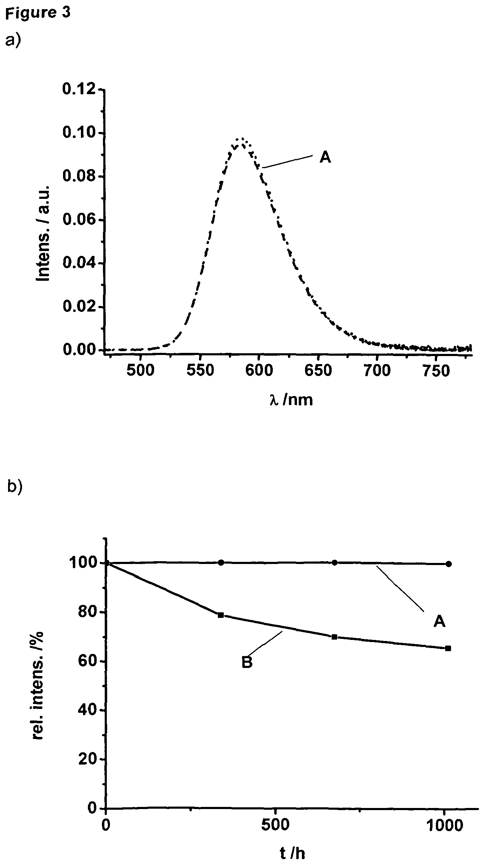

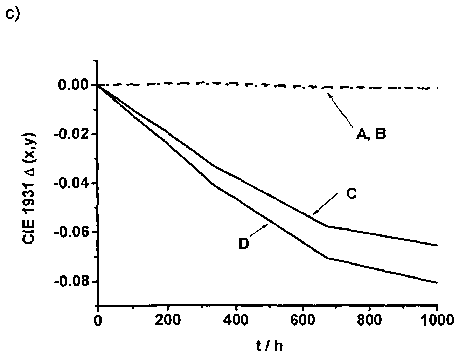

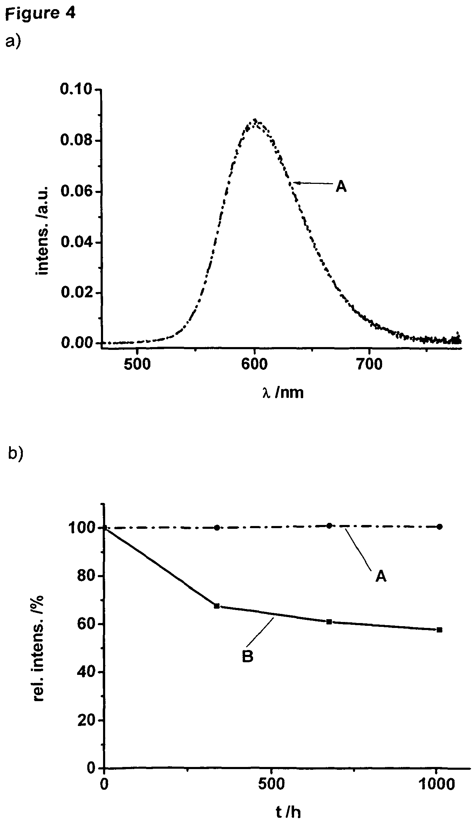

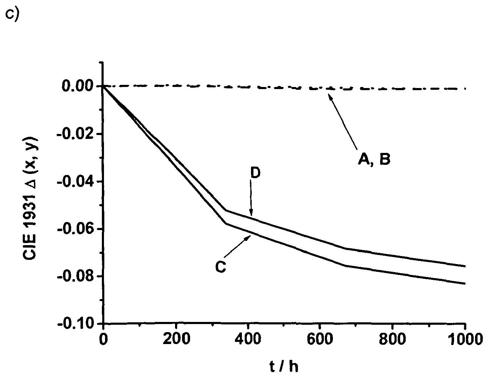

## Claims

1. Phosphor comprising a compound of the formula (I), (II) or (III),
(EA)₂₋ₓEuₓSiO₄ (I)
(EA)₃₋ₓEuₓSiO₅ (II)
(EA)_{3-x-y}MgEuₓMn_{y}Si₂O₈ (III)
where
EA stands for at least one element selected from Ca, Sr, and Ba, and might additionally contain Zn, Mg, and/or Cu;
x stands for a value from the range 0.01 ≤ x ≤ 0.25,
y stands for a value from the range 0 ≤ y ≤ 0.1,
**characterized in that** the compound contains a coating of aluminum oxide (alumina) which has been deposited by an atomic layer deposition process, wherein the deposit of alumina forms a conformal coating, **characterized in that** the thickest regions of the coating are no greater than 3x the thickness of the thinnest regions.

2. Phosphor according to claim 1 wherein EA is selected from Ba, Sr, Ca, Ba + Sr, Ba + Ca, Ba + Ca, Sr + Ca and Ba + Sr + Ca and wherein Zn, Mg, and/or Cu might additionally be present in any of these combinations, and is preferably selected from one or more of the elements Ba and Sr.

3. Phosphor according to claim 1 or 2 wherein x is a value in the range 0.03 ≤ x ≤ 0.20, preferably a value in the range 0.04 ≤ x ≤ 0.13.

4. Phosphor according to one or more of claims 1 to 3 wherein the coating has a thickness between 0.5 and 100 nm, preferably between 2 and 75 nm and in particular between 3 and 50 nm.

5. Method for the preparation of a phosphor according to one or more of claims 1 to 4, comprising the following process steps:
a) provision of a compound of formula (I), (II) or (III); and
b) forming a layer of aluminum oxide on the surface of the compound via an atomic layer deposition process.

6. Method according to claim 5, wherein the formation of the layer of aluminum oxide comprises the following steps:
b1) introduction of a purge/fluidizing gas;
b2) introduction of a mixture of carrier gas and first reagent;
b3) introduction of a purge/fluidizing gas and/or pull a vacuum to remove excess quantities of the first reagent as well as reaction by-products;
b4) introduction of a mixture of carrier gas and second reagent;
b5) introduction of a purge/fluidizing gas and/or pull a vacuum to remove excess quantities of the second reagent and reaction by-products;
b6) repeat steps b2) to b5) until desired coating thickness is obtained.

7. Method according to claim 6 wherein argon, nitrogen, other inert gas, or mixture of inert gases is used as the purge/fluidizing gas and argon, nitrogen, other inert gas, or mixture of inert gases is used as carrier gas.

8. Method according to claim 6 or 7 wherein trialkyl aluminum, in particular trimethyl aluminum or triethyl aluminum, or an aluminum trihalide, in particular aluminum trichloride, are used as the first reagent and an oxidizer, preferably selected from water, oxygen plasma species, ozone or alcohols is used as the second reagent.

9. Mixture comprising at least one phosphor according to one or more of claims 1 to 4 and at least one further phosphor, preferably a red-emitting, orange-emitting, green-emitting or cyan-emitting phosphor.

10. Shaped body comprising at least one phosphor according to one or more of claims 1 to 4, in particular a ceramic shaped body.

11. Use of a phosphor according to one or more of claims 1 to 4 as conversion phosphor, preferably for the partial or complete conversion of the blue or near-UV emission from a luminescent diode, or in electroluminescent materials, in particular in electroluminescent films.

12. Light source **characterized in that** it comprises a semiconductor and at least one phosphor according to one or more of claims 1 to 4 or a shaped body according to claim 10.

13. Light source according to Claim 12 wherein the semiconductor is a luminescent indium aluminium gallium nitride, in particular of the formula InᵢGaⱼAlₖN, where 0 ≤ i, 0 ≤ j, 0 ≤ k, and I + j + k = 1.

14. Lighting unit, in particular for the backlighting of display devices, **characterized in that** it comprises at least one light source according to claim 12 or 13.

15. Display device, in particular liquid-crystal display device, **characterized in that** it contains at least one lighting unit according to claim 14.

## Patentansprüche

1. Leuchtstoff enthaltend eine Verbindung der Formel (I), (II) oder (III),
(EA)₂₋ₓEuₓSiO₄ (I)
(EA)₃₋ₓEuₓSiO₅ (II)
(EA)_{3-x-y}MgEuₓMn_{y}Si₂O₈ (III)
wobei
EA für mindestens ein aus Ca, Sr und Ba ausgewähltes Element steht und zusätzlich Zn, Mg und/oder Cu enthalten kann;
x für einen Wert aus dem Bereich 0,01 ≤ x ≤ 0,25 steht,
y für einen Wert aus dem Bereich 0 ≤ y ≤ 0,1 steht,
**dadurch gekennzeichnet, dass** die Verbindung eine Beschichtung aus Aluminiumoxid enthält, das durch ein ALD(atomic layer deposition)-Verfahren abgeschieden wurde, bei dem die Abscheidung aus Aluminiumoxid eine konforme Beschichtung bildet, **dadurch gekennzeichnet, dass** die dicksten Bereiche der Beschichtung nicht größer als 3x die Dicke der dünnsten Bereiche sind.

2. Leuchtstoff nach Anspruch 1, bei dem EA aus Ba, Sr, Ca, Ba + Sr, Ba + Ca, Ba + Ca, Sr + Ca und Ba + Sr + Ca ausgewählt ist und bei dem Zn, Mg und/oder Cu zusätzlich in beliebigen dieser Kombinationen vorliegen können, und vorzugsweise aus einem oder mehreren der Elemente Ba und Sr ausgewählt ist.

3. Leuchtstoff nach Anspruch 1 oder 2, bei dem x ein Wert im Bereich 0,03 ≤ x ≤ 0,20, vorzugsweise ein Wert im Bereich 0,04 ≤ x ≤ 0,13 ist.

4. Leuchtstoff nach einem oder mehreren der Ansprüche 1 bis 3, bei dem die Beschichtung eine Dicke zwischen 0,5 und 100 nm, vorzugsweise zwischen 2 und 75 nm und insbesondere zwischen 3 und 50 nm aufweist.

5. Verfahren zur Herstellung eines Leuchtstoffs nach einem oder mehreren der Ansprüche 1 bis 4, umfassend die folgenden Verfahrensschritte:
a) Bereitstellen einer Verbindung der Formel (I), (II) oder (III); und
b) Bilden einer Schicht aus Aluminiumoxid auf der Oberfläche der Verbindung mittels eines ALD-Prozesses.

6. Verfahren nach Anspruch 5, bei dem die Bildung der Schicht aus Aluminiumoxid die folgenden Schritte umfasst:
b1) Einbringen eines Spül-/Wirbelgases;
b2) Einbringen eines Gemisches aus Trägergas und erstem Reagens;
b3) Einbringen eines Spül-/Wirbelgases und/oder Ziehen eines Vakuums, um Überschüsse des ersten Reagens sowie Nebenprodukte der Reaktion zu entfernen;
b4) Einbringen eines Gemisches aus Trägergas und zweitem Reagens;
b5) Einbringen eines Spül-/Wirbelgases und/oder Ziehen eines Vakuums, um Überschüsse des zweiten Reagens sowie Nebenprodukte der Reaktion zu entfernen;
b6) Wiederholen der Schritte b2) bis b5), bis die gewünschte Beschichtungsdicke erreicht ist.

7. Verfahren nach Anspruch 6, bei dem Argon, Stickstoff, anderes Inertgas oder Gemisch aus Inertgasen als Spül-/Wirbelgas verwendet wird und Argon, Stickstoff, anderes Inertgas oder Gemisch aus Inertgasen als Trägergas verwendet wird.

8. Verfahren nach Anspruch 6 oder 7, bei dem Trialkylaluminium, insbesondere Trimethylaluminium oder Triethylaluminium, oder ein Aluminiumtrihalogenid, insbesondere Aluminiumtrichlorid, als das erste Reagens verwendet werden und ein Oxidationsmittel, vorzugsweise ausgewählt aus Wasser, Sauerstoffplasmaspezies, Ozon oder Alkoholen als das zweite Reagens verwendet wird.

9. Gemisch enthaltend mindestens einen Leuchtstoff nach einem oder mehreren der Ansprüche 1 bis 4 und mindestens einen weiteren Leuchtstoff, vorzugsweise einen Rot emittierenden, Orange emittierenden, Grün emittierenden oder Cyan emittierenden Leuchtstoff.

10. Formkörper enthaltend mindestens einen Leuchtstoff nach einem oder mehreren der Ansprüche 1 bis 4, insbesondere ein keramischer Formkörper.

11. Verwendung eines Leuchtstoffs nach einem oder mehreren der Ansprüche 1 bis 4 als Konversionsleuchtstoff, vorzugsweise für die teilweise oder vollständige Konversion der blauen oder Nah-UV-Emission aus einer Lumineszenzdiode, oder in Elektrolumineszenzmaterialien, insbesondere in Elektrolumineszenzfolien.

12. Lichtquelle, **dadurch gekennzeichnet, dass** sie einen Halbleiter und mindestens einen Leuchtstoff nach einem oder mehreren der Ansprüche 1 bis 4 oder einen Formkörper nach Anspruch 10 enthält.

13. Lichtquelle nach Anspruch 12, bei dem der Halbleiter ein lumineszierendes Indium-Aluminium-Gallium-Nitrid, insbesondere der Formel InᵢGaⱼAlₖN ist, wobei 0 ≤ i, 0 ≤ j, 0 ≤ k und I + j + k = 1.

14. Beleuchtungseinheit, insbesondere für die Hintergrundbeleuchtung von Anzeigevorrichtungen, **dadurch gekennzeichnet, dass** sie mindestens eine Lichtquelle nach Anspruch 12 oder 13 enthält.

15. Anzeigevorrichtung, insbesondere Flüssigkristall-Anzeigevorrichtung, **dadurch gekennzeichnet, dass** sie mindestens eine Beleuchtungseinheit nach Anspruch 14 enthält.

## Revendications

1. Phosphore comprenant un composé de la formule (I), (II) ou (III) :
(EA)₂₋ₓEuₓSiO₄ (I)
(EA)₃₋ₓEuₓSiO₅ (II)
(EA)_{3-x-y}MgEuₓMn_{y}Si₂O₈ (III)
formules dans lesquelles :
EA représente au moins un élément qui est sélectionné parmi Ca, Sr et Ba, et pourrait contenir de façon additionnelle Zn, Mg et/ou Cu ;
x représente une valeur prise au sein de la plage 0,01 ≤ x ≤ 0,25 ;
y représente une valeur prise au sein de la plage 0 ≤ y ≤ 0,1 ;
**caractérisé en ce que** le composé contient un revêtement en oxyde d'aluminium (alumine) qui a été déposé au moyen d'un processus de dépôt de couche atomique, dans lequel le dépôt d'alumine forme un revêtement conforme, **caractérisé en ce que** les régions les plus épaisses du revêtement ne présentent pas une épaisseur supérieure à 3 fois l'épaisseur des régions les plus minces.

2. Phosphore selon la revendication 1, dans lequel EA est sélectionné parmi Ba, Sr, Ca, Ba + Sr, Ba + Ca, Sr + Ca et Ba + Sr + Ca et dans lequel Zn, Mg et/ou Cu pourraient de façon additionnelle être présents selon n'importe laquelle de ces combinaisons, et est de préférence sélectionné parmi un ou plusieurs des éléments Ba et Sr.

3. Phosphore selon la revendication 1 ou 2, dans lequel x est une valeur prise au sein de la plage 0,03 ≤ x ≤ 0,20, de préférence une valeur prise au sein de la plage 0,04 ≤ x ≤ 0,13.

4. Phosphore selon une ou plusieurs des revendications 1 à 3, dans lequel le revêtement présente une épaisseur entre 0,5 et 100 nm, de préférence entre 2 et 75 nm et en particulier entre, 3 et 50 nm.

5. Procédé pour la préparation d'un phosphore selon une ou plusieurs des revendications 1 à 4, comprenant les étapes de processus qui suivent :
a) la fourniture d'un composé de la formule (I), (II) ou (III) ; et
b) la formation d'une couche en oxyde d'aluminium sur la surface du composé via un processus de dépôt de couche atomique.

6. Procédé selon la revendication 5, dans lequel la formation de la couche en oxyde d'aluminium comprend les étapes qui suivent :
b1) l'introduction d'un gaz de purge/fluidification ;
b2) l'introduction d'un mélange d'un gaz porteur et d'un premier réactif ;
b3) l'introduction d'un gaz de purge/fluidification et/ou la création d'un vide afin d'enlever des quantités en excès du premier réactif de même que des sous-produits de réaction ;
b4) l'introduction d'un mélange d'un gaz porteur et d'un second réactif ;
b5) l'introduction d'un gaz de purge/fluidification et/ou la création d'un vide afin d'enlever des quantités en excès du second réactif et des sous-produits de réaction ;
b6) la répétition des étapes b2) à b5) jusqu'à ce qu'une épaisseur de revêtement souhaitée soit obtenue.

7. Procédé selon la revendication 6, dans lequel de l'argon, de l'azote, un autre gaz inerte ou un mélange de gaz inertes est utilisé en tant que gaz de purge/fluidification et de l'argon, de l'azote, un autre gaz inerte ou un mélange de gaz inertes est utilisé en tant que gaz porteur.

8. Procédé selon la revendication 6 ou 7, dans lequel un trialkylaluminium, en particulier du triméthylaluminium ou du triéthylaluminium, ou un trihalogénure d'aluminium, en particulier du trichlorure d'aluminium, sont utilisés en tant que premier réactif et un oxydant, de préférence sélectionné parmi l'eau, les espèces de plasma d'oxygène, l'ozone ou les alcools, est utilisé en tant que second réactif.

9. Mélange comprenant au moins un phosphore selon une ou plusieurs des revendications 1 à 4 et au moins un autre phosphore, de préférence un phosphore d'émission de rouge, d'émission d'orange, d'émission de vert ou d'émission de cyan.

10. Corps conformé comprenant au moins un phosphore selon une ou plusieurs des revendications 1 à 4, en particulier un corps conformé en céramique.

11. Utilisation d'un phosphore selon une ou plusieurs des revendications 1 à 4 en tant que phosphore de conversion, de préférence pour la conversion partielle ou complète de l'émission de bleu ou des UV proches en provenance d'une diode luminescente, ou dans des matériaux électroluminescents, en particulier dans des films électroluminescents.

12. Source de lumière **caractérisée en ce qu'**elle comprend un semiconducteur et au moins un phosphore selon une ou plusieurs des revendications 1 à 4 ou un corps conformé selon la revendication 10.

13. Source de lumière selon la revendication 12, dans laquelle le semiconducteur est un nitrure d'indium, d'aluminium et de gallium luminescent, en particulier de la formule InᵢGaⱼAlₖN, où 0 ≤ i, 0 ≤ j, 0 ≤ k, et l + j + k = 1.

14. Unité d'éclairage, en particulier pour l'éclairage arrière de dispositifs d'affichage, **caractérisée en ce qu'**elle comprend au moins une source de lumière selon la revendication 12 ou 13.

15. Dispositif d'affichage, en particulier un dispositif d'affichage à cristaux liquides, **caractérisé en ce qu'**il contient au moins une unité d'éclairage selon la revendication 14.
